# EUROPEAN PATENT SPECIFICATION

(11) **EP 2 535 764 B1**
(45) Date of publication and mention of the grant of the patent: **22.05.2019**
(21) Application number: 12171610.4
(22) Date of filing: 12.06.2012
(51) Int. Cl.: G02F 1/13, G02F 1/1333

(54) **Substrate tray and manufacturing method of a flexible electronic display device with said substrate tray**
Substratträger und Herstellungsverfahren für eine flexible elektronische Anzeigevorrichtung mit dem Substratträger
Plateau porteur de substrat et procédé de fabrication d'un dispositif électronique d'affichage flexible avec le plateau porteur de substrat

(30) Priority: 14.06.2011 CN 201110159589
(43) Date of publication of application: 19.12.2012
(73) Proprietor: BOE Technology Group Co., Ltd., Beijing 100015 (CN)
(72) Inventor: Guo, Wei, 100176 Beijing (CN); Lee, Woobong, 100176 Beijing (CN); Guo, Jing, 100176 Beijing (CN); Zhang, Hang, 100176 Beijing (CN); Ren, Qingrong, 100176 Beijing (CN)
(74) Representative: Brötz, Helmut

(56) References cited:
- US-A- 6 051 067
- US-A1- 2010 279 576
- US-A1- 2011 120 619
- US-B1- 7 595 928

## Description

### TECHNICAL FIELD

The present disclosure relates to flexible electronic display devices, in particular, to a substrate tray and a manufacturing method of a flexible electronic display device using the substrate tray.

### BACKGROUND

Flexible display technology mainly utilizes flexible electronics technology, which is to install electronic components and materials of flexible display medium on a flexible or bendable substrate in such a way that the electronic device has a property of being able to be bent or curled into any shape.

According to the current application state, flexible electronic display devices may be classified into the following types:
(1) Flexible electronic display devices possessing the image quality of paper: its application in the future lies in books or advertising publication boards or the like market segments, and therefore it needs to possess product properties of light weight and thinness, low power consumption, etc, whereas the property of bendability is not a key point. The current appropriate technologies are LCD, EPD and MEMS.
(2) Flexible electronic display devices possessing a slightly-bendable property: it must possess properties of low power consumption, thickness of preferably below 0.5 mm and better image quality, whereas it is not required to have high bending degree. EPD, OLED and LCD technologies are very suitable for its development.
(3) Rollable flexible electronic display devices: it must possess properties of low power consumption, thickness of preferably below 0.5 mm, and better image quality, it is also required for itself to be able to be bent or even rolled. EPD, OLED and LCD technologies are very suitable for its development.

A basic structure of a flexible electronic display device may be divided into three main layers: a substrate, an intermediate display medium layer, and an encapsulation. Compared with a traditional hard electronic display device made of a hard glass substrate, a flexible electronic display device using materials such as ultra-thin glass, plastic or ultra-thin metal as a substrate of an electronic display device, has many advantages like light weight, thinness, softness, bendability, and high impact-resistance, which makes it more convenient for carriage.

It is crucial to select a flexible substrate in the flexible display technology, for it is the key for the bendability performance of a flexible display. Table 1 is a comparison of relevant properties of several types of commonly used materials for a flexible substrate.

**Table 1**

| performance parameters | ultra-thin glass | metal sheet | PET | PEN | FRP | PES | PI |
|---|---|---|---|---|---|---|---|
| light transmittence (%) | 90 | opaque | 91 | 87 | 90 | 90 | YELLOW |
| CTE(ppm/°C) | <10 | <20 | 15 | 13 | 14 | 54 | 50 |
| Tg(°C) | >350 | >350 | 78 | 120 | >350 | 225 | 340 |
| impact-resistance | poor | good | excellent | excellent | excellent | excellent | excellent |
| Manufacturing mode | Sheet by Sheet | Roll-to-Roll | | | | | |

### (1) Ultra-thin Glass Substrate

When a glass substrate has thickness of below 0.2mm, it begins to exhibit bendable property. Since a flexible electronic display device based on a glass substrate may substantially follow the existing mature manufacturing processes and have excellent display performance and good reliability, a number of panel manufacturers have tried to develop an LCD's glass substrate having a thickness of 0.2 mm or less to achieve a bendable flexible electronic display device. But the ultra-thin glass substrate also has many disadvantages such as high-cost for polishing and high fragility of glass, thereby resulting in low production yield rate and poor flexure performance, which makes it can only be used to make a slightly-bendable display but unable to match a roll-to-roll mode of manufacturing procedure.

### (2) Ultra-thin Metal

A metal foil as a flexible substrate has many good properties. For instance, it has an excellent heat-resistant manufacturing procedure, and has a thermal expansion coefficient (CTE) similar to glass based-material, also has good chemical-resistance and air-resistance, as well as excellent ductibility, which makes it suitable for developing a flexible electronic display device and suitable for a roll-to-roll manufacturing mode. The metal foil however is opaque. Therefore it only applies to a reflective display panel. Besides, the metal foil surface has surface roughness problem, which once became its technical bottleneck. Nevertheless, due to the superior properties of a metal foil, many existing flexible electronic display devices are based on a metal foil substrate.

### (3) Plastic Substrate

Due to property limitations of a glass substrate and a metal substrate of themselves, a plastic substrate will be the best choice in the future for a flexible display as it has good light transmittance, excellent flexure and good surface flatness. But as a flexible electronics display device substrate, plastic also has its problems to be overcome, such as heat resistance, dimensional stability and poor air-resistance and other issues. Plastic materials generally used for a display substrate are PET (Poly Ethylene Terephthalate), PEN (Poly Ethylene Naphthalene), PES (Poly Ether Sulfones), PI (Poly Imide), FRP (Fiber Reinforced Plastics) and other materials. Among them, PET material has more applications because of its low cost, but its low glass transition temperature would directly result in a low-temperature manufacturing procedure; PEN material has high glass transition temperature, and has better chemical-resistance and dimensional stability, and therefore it is used for developing a flexible OLED, but not suitable for a flexible LCD because of its high retardation; PES material has high glass transition temperature, and yet relatively poor dimensional stability; so far, FRP material developed by SUMITOMO is a type of plastic material possessing good comprehensive performances, but no report is presented for its application. In addition, due to poor air/water-resistance and even poor chemical-resistance of a plastic substrate, plastic must be subjected to multi-coating treatments when it is used as a flexible display substrate.

The technical bottleneck for a flexible LCD using a plastic substrate lies in that, a plastic based-material has properties such as low hardness, high coefficient of thermal expansion, and poor high-temperature-resistance, and therefore conventional LCD technologies can not be simply transplanted to a plastic based-material. A plastic substrate suitable for LCD producing processes is required to reach hardness of 6H, whereas common plastic substrates can not reach this level. For example, a PET substrate can only reach 3H. In addition, a plastic substrate's CTE is relatively large, resulting in relatively poor dimensional stability and tendency to curl under heat and force. So far, these two issues can be solved with a substrate fixing and removing technology, which comprises: firstly fixing a plastic substrate on a rigid substrate such as a glass substrate, so as to accomplish the substrate's conveyance and respective stages of producing process, and then removing it from the rigid substrate. Here, one may use an adhesive material with different adhesion in two sides to bond a plastic substrate and a rigid substrate together, so that the side of bonding the plastic substrate has weak adhesion, and the side of bonding the glass substrate has strong adhesion, and thus it is easy to remove the plastic substrate. Also, a cold-peelable adhesive material may be used, so that by reducing its adhesion through cooling, a plastic substrate can be peeled off from a rigid substrate. In addition, due to strong acid, strong alkali and high temperature environments in an LCD's manufacturing procedure, it is also required for the adhesive material to possess very good chemical-resistance and high-temperature-resistance.

Compared with the existing TFT-LCD technology, the technologies in the above-mentioned substrate fixing and removing processes will not only add new adhesive material and new equipments, but also probably generate a lot of defects such as scratches, static electricity and damage during fixing and taking-off processes of a plastic substrate, thereby resulting in reduction of production yield rate.

In addition, ultraviolet irradiation or laser technologies may be used to separate a flexible substrate and a glass substrate. An example is Electronics on Plastic by Laser Release (EPLaR) from PVI (a U.S. company, founded in 1947 and famous for new building materials' producing and developing), which may adopt a traditional TFT-LCD or E-paper production line with a glass substrate being used as a supporting base, except that a 10 µm thick polymer layer needs to be added onto the glass substrate. As long as the adhesive surface of an appropriate type of polymer is experienced an interface processing, the polymer will be able to very firmly attach to the glass substrate, and thus the polymer layer can withstand all processes for producing a TFT. After completion of a flexible device, the polymer layer is released from the glass substrate through laser processing, and the polymer layer becomes the flexible electronic display device's plastic substrate. However, it is still unknown whether or not that type of polymer material is able to withstand chemical vapor deposition and tests in other high-temperature processing equipments such as annealing and rapid thermal annealing for manufacturing an LCD or an AMOLED. Moreover, new raw materials and equipments and thus increased cost are added to the existing TFT-LCD and AMOLED production lines.
US 2010/279576 A1 relates to a method of manufacturing a flexible display device. The flexible display device manufacturing method includes: preparing a support substrate; coating a sealant on edge areas of the support substrate; combining a flexible substrate and the support substrate coated with the sealant in a vacuum state; hardening the sealant between the support substrate and the flexible substrate; forming display components used in a configuration of the flexible display device on the flexible substrate; and cutting the flexible substrate along a cutting line on the flexible substrate to separate the flexible substrate from the support substrate. US 6,051,067 A relates to a wafer securing device and method for securing a planar plate on a wafer having a hollowed-out portion, the device including a substrate for receiving the wafer; a groove provided on the substrate and having an opening, the hollowed-out portion corresponding to the groove when the wafer is placed on the substrate; and an air extracting equipment for extracting air from the groove when the wafer is placed on the substrate so that the planar plate placed on the wafer is secured to the wafer by means of a vacuum suction force.

### SUMMARY

The present disclosure is to solve the technical problems of how to make use of the existing processing equipments and processing conditions, to produce flexible electronic display devices with technologies which save materials and equipment investment.

According to embodiments of the present disclosure, a substrate tray for supporting a flexible substrate during manufacturing of a flexible electronic display device is provided. The substrate tray comprises a tray baseboard, and the tray baseboard has a groove zone in which a plurality of grooves are formed in the tray baseboard, wherein the depths of the grooves are no larger than 1 µm, and the lengths of the bottom sides of the cross-section profiles of the grooves are m µm to n mm, in which, 1≤m≤10, 1≤n≤10.

Preferably, the tray baseboard further has a planar edge zone at the periphery of the groove zone.

Preferably, the plurality of grooves are strip-like grooves extending to edges of the groove zone.

Preferably, the plurality of strip-like grooves comprise a plurality of transversally-extending strip-like grooves and a plurality of vertically-extending strip-like grooves.

The strip-like grooves may extend from one side edge of the groove zone toanother side edge on the opposite of said one side edge.

The cross-section profiles of the grooves may be one or more selected from a group consisted of circle, ellipse and polygon.

The material of the tray baseboard may be selected from a group consisted of glass, metal and plastic.

According to other embodiments of the present disclosure, a method for manufacturing a flexible electronic display device is provided. The method comprises the following steps: Step 1: providing a substrate tray comprising a tray baseboard, the tray baseboard having a groove zone in which a plurality of grooves are formed in the tray baseboard; Step 2: placing a flexible substrate on the groove zone of the tray baseboard of the substrate tray; Step 3: placing the substrate tray together with the flexible substrate into a chamber to perform vacuum-pumping processing, and depositing a fixing layer on the flexible substrate, the fixing layer's outer edges covering and extending beyond the external boundary of the flexible substrate, thereby fixing the flexible substrate on the substrate tray, and maintaining the vacuum degree in the grooves of the substrate tray below the flexible substrate; and Step 4: performing electronic display device producing processes on the flexible substrate, and then separating the flexible substrate from the substrate tray.

Preferably, the tray baseboard of the substrate tray provided in Step 1 has also a planar edge zone at periphery of the groove zone.

Preferably, in the step 4, separating the flexible substrate from the substrate tray comprises: Step 41: applying photoresist on the fixing layer, and then exposing and developing the photoresist on the external boundary of the flexible substrate and outside of the external boundary of the flexible substrate; and Step 42: etching off the fixing layer which is not covered by the photoresist on the external boundary of the flexible substrate and outside of the external boundary of the flexible substrate, and peeling off the remaining photoresist, so that the vacuum between the flexible substrate and the substrate tray is released, thereby separating the flexible substrate from the substrate tray.

Preferably, in the Step 3, the thickness of the fixing layer is deposited to be 0.05 µm - 10 µm.

The substrate tray and the method for manufacturing a flexible electronic display device using the substrate tray according to the above technical solutions, can be conducted on the existing TFT-LCD, the E-paper, AMOLED, LTPS, Oxide TFT, Organic TFT production lines, which on one hand can make use of the existing processing equipments and processing conditions, and on the other hand save a lot of material and equipment investment.

### BRIEF DESCRIPTION OF THE DRAWINGS

Fig. 1 is a top view of the substrate tray in a first embodiment of the present disclosure;
Fig. 2 is a sectional view of a groove in the substrate tray shown in Fig. 1;
Fig. 3 is a structural top view of a flexible substrate adhered on a substrate tray in a third embodiment of the present disclosure;
Fig. 4 is a sectional view of a groove after a flexible substrate being adhered on the substrate tray shown in Fig. 3;
Fig. 5 is a sectional view of a groove and its external boundary on a substrate tray, after a fixing layer is deposited on the flexible substrate and the substrate tray in the third embodiment of the present disclosure;
Fig. 6 is a sectional view after etching off the fixing layer on the external boundary and its outside region of a flexible substrate shown in Fig. 5.

### REFERENCE NUMBER

1: tray baseboard; 2: groove; 3: flexible substrate; 4: fixing layer.

### DETAILED DESCRIPTION OF THE PREFERRED EMBODIMENTS

Below with reference to accompanying drawings and embodiments, the specific implementations of the present disclosure will be further described in detail. The following embodiments are used for explaining the present disclosure, but not for limiting the scope of the present disclosure.

### First Embodiment

This embodiment provides a substrate tray for supporting a flexible substrate. Exemplary producing processes of the substrate tray are described as below.

First, it is needed to make a mask which comprises a plurality of light-transmitting regions and light-shielding regions. The plurality of light-transmitting regions and light-shielding regions may be alternatively provided and regularly distributed on the mask. Since the patterns of the substrate tray is not particularly limited, the patterns of the light-transmitting regions or the light-shielding regions of the mask may be in strip-like shape; the strip-like patterns interlace and extend to edge zone of the mask.

After the manufacture of the mask is completed, the material of the substrate tray is selected. For instance, glass, metal, plastic or the like may be chosen as a tray baseboard. Then the tray baseboard is cleaned, and photoresist is applied on the tray baseboard and subjected to a pre-curing process, in which the thickness of the photoresist is 1µm -3µm; then, the photoresist on the tray baseboard is exposed with the prepared mask, developed and cured. Positive photoresist and/or negative photoresist may be used as photoresist in this embodiment. Next, the regions which are not protected by the photoresist on the tray baseboard are etched. Grooves are formed on the tray baseboard by using dry etching or wet etching depending on the materials used for the tray baseboard. Finally, the photoresist on the tray baseboard is peeled off, and after a cleaning process, the substrate tray as required is obtained.

The substrate tray in this embodiment is mainly used to support a flexible substrate for manufacturing a flexible electronic display device. Therefore, in order to maintain and release vacuum, the depth of the grooves in the substrate tray is preferably no larger than 1µm, and the side lengths of the cross-section profiles of the grooves are several microns to several millimeters, i.e. m µm - n mm, in which, 1≤m≤10, 1≤n≤10.

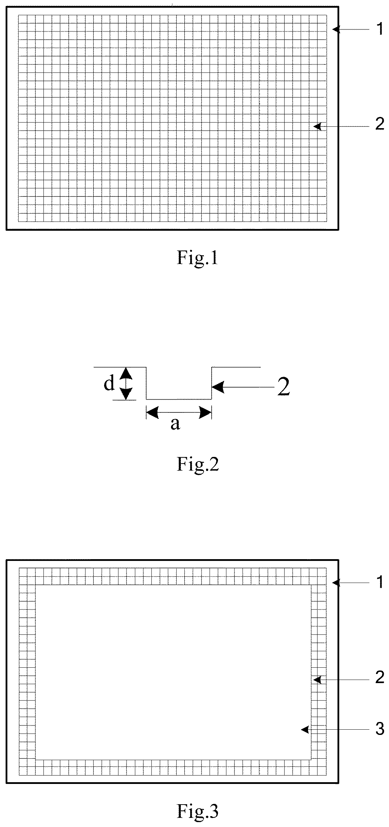

According to the above described method for manufacturing a substrate tray, a substrate tray comprising a tray baseboard can be obtained, in which the tray baseboard has a groove zone provided with a plurality of grooves. The tray baseboard can further have a planar edge zone at the periphery of the groove zone. Fig. 1 illustrates a substrate tray according to the present embodiment. On the rectangle tray baseboard 1, a plurality of transversally-extending strip-like grooves and a plurality of vertically-extending strip-like grooves extend to side edges of the groove zone. Fig. 2 shows a sectional view of one of the grooves in the substrate tray. It can be seen from the figure that, grooves 2 are provided at intervals. The substrate tray in this embodiment is mainly used to support a flexible substrate for manufacturing a flexible electronic display device, and therefore, in order to maintain and release vacuum, the depth d of the grooves 2 is preferably no larger than 1µm, and the side lengths of the cross-section profiles of the grooves are preferably m µm - n mm, in which, 1≤m≤10, 1≤n≤10.

In this embodiment, the material of the tray baseboard 1 may be glass, metal or plastic. In addition, because the cross-section profiles of the grooves 2 will not affect the substrate tray's supporting to a flexible substrate and the manufacturing of a flexible electronic display device, the cross-section profiles of the grooves 2 are thus not limited to rectangles, but may also be one or more selected from a group consisted of other polygons, circle, ellipse and their combinations, or irregular geometries.

### Second Embodiment

The substrate tray and the manufacturing procedure thereof in this embodiment are similar to the substrate tray and the manufacturing procedure thereof in the first embodiment, with the differences as below.

According to the present embodiment, during the manufacturing procedure of the substrate tray, light-transmitting regions or light-shielding regions of the required mask are provided at intervals, and the patterns of the light-transmitting regions or the light-shielding regions are one or more selected from a group consisted of circle, ellipse, and polygons. Thus the obtained substrate tray has a groove zone on which the grooves are provided at intervals and mutually not communicated.

### Third Embodiment

According to the present embodiment, a flexible electronic display device can be manufactured by using the substrate tray described in the first embodiment and the second embodiment.

First, provide a substrate tray comprising a tray baseboard, said tray baseboard having a groove zone provided with a plurality of grooves. The tray baseboard may further comprise a planar edge zone at the periphery of the groove zone. As shown in Fig.3, the external boundary of the tray baseboard 1 is a planar edge zone, on which no grooves are provided.

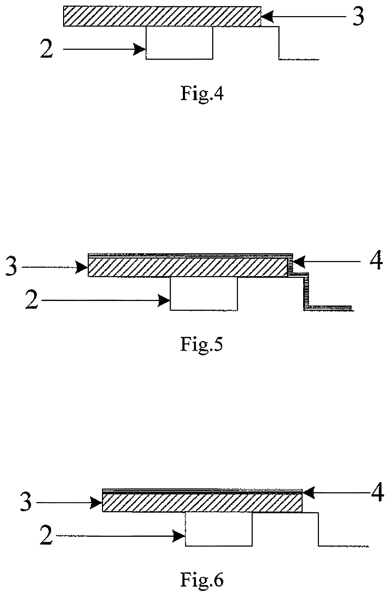

Next, a flexible substrate is placed on the groove zone of the substrate tray. The outer boundary of the flexible substrate may be located on a planar edge zone outside the groove zone. Fig.4 illustrates a sectional view of the groove region of the substrate tray at the external boundary of the flexible substrate shown in Fig. 3.

In this embodiment, depending on different types of flexible electronic display devices to be manufactured, ultra-thin glass, thin metal or plastic can be used as the flexible substrate.

Then, the substrate tray adhered with the flexible substrate is placed into a chamber for vacuum-pumping processing, and a fixing layer is deposited on the flexible substrate. Said fixing layer's outer edges cover and extend beyond the external boundary of the flexible substrate, thereby fixing the flexible substrate onto the substrate tray and keeping the vacuum inside the grooves 2 in the substrate tray below the flexible substrate. Taken one covered groove region at the external boundary of the flexible substrate as an example, the sectional view of Fig.5 illustrates the fixing layer deposited on the flexible substrate and on its external boundary as well as on the substrate tray outside of the external boundary of the flexible substrate, wherein the flexible substrate 3 covers on the substrate tray, and the fixing layer 4 covers on the flexible substrate 3 and the substrate tray.

In this embodiment, the fixing layer deposited on the flexible substrate and the substrate tray may be an insulating layer or a conductive layer, its material may be organic material, inorganic material or metal material, and the deposition of the fixing layer may be realized with chemical vapor deposition or physical vapor deposition. Deposition of an insulating layer or a conductive layer on the flexible substrate is an essential step in producing processes of a flexible electronic display device. At the same time of performing that step, by depositing an insulating layer or a conductive layer on external boundary of the flexible substrate and on the substrate tray outside of the external boundary of the flexible substrate, the flexible substrate can be fixed on the substrate tray, and thus the flexible substrates is supported by the rigid substrate tray during each step of producing process of a flexible electronic display device, so as to avoid shortcomings such as high defect rate and low yield rate caused by a flexible electronic display device's inherent properties of hardness, acid-and-alkali resistance and high-temperature resistance. As the insulating layer or the conductive layer on the flexible substrate requires, the thickness of the fixing layer is preferably 0.05 µm - 10 µm.

Finally, the substrate tray is moved out of the vacuum chamber for performing producing processes of a flexible electronic display device on the flexible substrate, and then the flexible substrate is separated from the substrate tray.

After the substrate tray has been moved out of the vacuum chamber to an atmospheric environment, the flexible substrate is tightly adhered to the substrate tray by the atmospheric pressure. In order to prevent the penetration of moisture and other substances, no additional process is performed during deposition of the fixing layer.

In this embodiment, for separating the flexible substrate from the substrate tray, first, photoresist is to be applied on the fixing layer and pre-cured, and then by using another mask, the photoresist on the external boundary of the flexible substrate and outside of the external boundary is exposed, developed and cured. That is, through the above-described photoresist applying, pre-curing, exposing, developing and curing processes, the surface region of the flexible substrate and the region on the substrate tray having no fixing layer deposited thereon are protected, whereas in the other regions the positive photoresist is exposed and developed. Then, through the etching process the fixing layer in the developed region is etched off, the photoresist in other regions on the flexible substrate and the substrate tray is peeled off, and thus the vacuum between the flexible substrate and the substrate tray is released, and the flexible substrate is separated from the substrate tray.

Fig. 6 shows an illustration after the fixing layer on the external boundary of the flexible substrate and on the substrate tray outside of the external boundary of the flexible substrate as shown in Fig. 5 is etched off, with only the fixing layer 4 on the flexible substrate 3 remained. In this embodiment, depending on different types of the material of the fixing layer, dry etching or wet etching is adopted to remove the fixing layer on the external boundary of the flexible substrate and on the substrate tray outside of the external boundary of the flexible substrate.

As can be seen from the above two embodiments, a substrate tray with grooves is produced in the embodiments of the present disclosure. Said substrate tray is used to support a flexible substrate for producing a flexible electronic display device without adhesive for bonding the flexible substrate to the substrate tray. With the grooves in the substrate tray, the flexible substrate is fixed to the substrate tray by maintaining vacuum inside the grooves during deposition of a conductive layer or an insulating layer. After a certain stage of the manufacturing procedure of the flexible electronic display device is reached, the flexible substrate and the substrate tray are separated by conventional exposing, developing, and etching, such that the key processes for producing a flexible electronic display device are completed. Moreover, the substrate tray can be cleaned and reused after one manufacturing procedure of a flexible electronic display device, which reduces cost for producing a flexible electronic display device. Further, the whole procedure of a flexible electronic display device is accomplished by using the existing processing equipments and processing conditions, and therefore, it can be conducted on the TFT-LCD, the E-paper, AMOLED, LTPS, Oxide TFT, Organic of TFT production lines, and has a wide range of applications.

The above description is only preferred implementations of the present disclosure. It should be noted to the ordinary skilled in the art that, modifications and alternatives without departing from the principles of the present disclosure can be made to the present disclosure, also the modifications and alternatives should be regarded as in the protection scope of the present disclosure.

## Claims

1. A substrate tray suitable for supporting a flexible substrate during manufacturing of a flexible electronic display device on said flexible substrate, wherein, it comprises a tray baseboard (1), and the tray baseboard (1) has a groove zone in which a plurality of grooves (2) are formed in the tray baseboard (1), **characterized in that** the depths of the grooves (2) are no larger than 1 µm, and the lengths of the bottom sides of the cross-section profiles of the grooves (2) are m µm to n mm, in which, 1≤m≤10, 1≤n≤10.

2. The substrate tray according to Claim 1, wherein, the tray baseboard also has a planar edge zone at the periphery of the groove zone.

3. The substrate tray according to Claim 1 or 2, wherein, the plurality of grooves (2) are strip-like grooves (2) extending to edges of the groove zone.

4. The substrate tray according to one of the previous claims, wherein, the plurality of strip-like grooves (2) comprise a plurality of transversally-extending strip-like grooves (2) and a plurality of longitudinally-extending strip-like grooves.

5. The substrate tray according to one of the previous claims, wherein, the strip-like grooves (2) extend from one side edge of the groove zone to another side edge on the opposite of said one side edge.

6. The substrate tray according to one of the previous claims, wherein, the cross-section profiles of the grooves (2) are one or more selected from a group consisted of circle, ellipse and polygon.

7. The substrate tray according to one of the previous claims, wherein, the material of the tray baseboard (1) is selected from a group consisted of glass, metal and plastic.

8. A method of manufacturing a flexible electronic display device, **characterized in that**, it comprises the following steps:
Step 1: providing a substrate tray according to one of Claims 1 to 7, said substrate tray comprising a tray baseboard (1), the tray baseboard (1) having a groove zone in which a plurality of grooves (2) are formed in the tray baseboard (1),
Step 2: placing a flexible substrate (3) on the groove zone of the tray baseboard (1) of the substrate tray;
Step 3: placing the substrate tray together with the flexible substrate (3) into a chamber to perform vacuum-pumping processing, and depositing a fixing layer (4) on the flexible substrate (3), the fixing layer's outer edges covering and extending beyond the external boundary of the flexible substrate (3), thereby fixing the flexible substrate (3) on the substrate tray while maintaining the vacuum degree in the grooves (2) of the substrate tray below the flexible substrate (3); and
Step 4: performing electronic display device producing processes on the flexible substrate, and then separating the flexible substrate (3) from the substrate tray.

9. The method for manufacturing a flexible electronic display device according to Claim 8, wherein, the tray baseboard (1) of the substrate tray provided in Step 1 has also a planar edge zone at periphery of the groove zone.

10. The method for manufacturing a flexible electronic display device according to Claim 8 or 9, wherein, in the step 4, separating the flexible substrate (3) from the substrate tray comprises:
Step 41: applying photoresist on the fixing layer (4), and then exposing and developing the photoresist on the external boundary of the flexible substrate (3) and outside of the external boundary of the flexible substrate (3); and
Step 42: etching off the fixing layer (4) which is not covered by the photoresist on the external boundary of the flexible substrate (3) and outside of the external boundary of the flexible substrate (3), and peeling off the remaining photoresist, so that the vacuum between the flexible substrate (3) and the substrate tray is released, thereby separating the flexible substrate (3) from the substrate tray.

11. The method for manufacturing a flexible electronic display device according to one of Claim 8-10, wherein, in the Step 3, the thickness of the fixing layer (4) is deposited to be 0.05 µm - 10 µm.

## Patentansprüche

1. Substratablage, geeignet zum Abstützen eines flexiblen Substrats während der Herstellung einer flexiblen elektronischen Anzeigevorrichtung auf dem flexiblen Substrat, wobei sie eine Ablage-Basisplatte (1) umfasst und die Ablage-Basisplatte (1) eine Rillenzone aufweist, in welcher eine Mehrzahl von Rillen (2) in der Ablage-Basisplatte gebildet ist, **dadurch gekennzeichnet, dass** die Tiefen der Rillen (2) nicht größer als 1 µm sind und wobei die Längen der Unterseiten der Querschnittsprofile der Rillen (2) m µm bis n mm beträgt, wobei 1 ≤m≤10, 1≤n≤10 ist.

2. Substratablage gemäß Anspruch 1, wobei die Ablage-Basisplatte eine planare Randzone an der Peripherie der Rillenzone aufweist.

3. Substratablage gemäß Anspruch 1 oder 2, wobei die Mehrzahl von Rillen (2) streifenartige Rillen (2) sind, die sich zu Rändern der Rillenzone erstrecken.

4. Substratablage gemäß einem der vorangehenden Ansprüche, wobei die Mehrzahl von streifenartigen Rillen (2) eine Mehrzahl von sich transversal erstreckenden streifenartigen Rillen (2) und eine Mehrzahl von sich längserstreckenden streifenartigen Rillen umfasst.

5. Substratablage gemäß einem der vorangehenden Ansprüche, wobei die streifenartigen Rillen (2) sich von einem Seitenrand der Rillenzone zu einem anderen Seitenrand gegenüberliegend zu dem einen Seitenrand erstrecken.

6. Substratablage gemäß einem der vorangehenden Ansprüche, wobei die Querschnittsprofile der Rillen (2) einzeln oder zu mehreren gewählt sind von einer Gruppe, die aus Kreis, Ellipse und Polygon besteht.

7. Substratablage gemäß einem der vorangehenden Ansprüche, wobei das Material der Ablage-Basisplatte (1) von einer Gruppe, die aus Glas, Metall und Kunststoff gebildet ist, gewählt ist.

8. Verfahren zur Herstellung einer flexiblen elektronischen Anzeigevorrichtung, **dadurch gekennzeichnet, dass** es die folgenden Schritte umfasst:
Schritt 1: Bereitstellen einer Substratablage gemäß einem der Ansprüche 1 bis 7, wobei die Substratablage eine Ablage-Basisplatte (1) umfasst, wobei die Ablage-Basisplatte (1) eine Rillenzone aufweist, in welcher eine Mehrzahl von Rillen (2) in der Ablage-Basisplatte (1) gebildet ist,
Schritt 2: Platzieren eines flexiblen Substrats (3) auf der Rillenzone der Ablage-Basisplatte (1) der Substratablage;
Schritt 3: Platzieren der Substratablage zusammen mit dem flexiblen Substrat (3) in einer Kammer, um einen Vakuumpumpprozess durchzuführen, und Abscheiden einer Befestigungsschicht (4) auf dem flexiblen Substrat (3), wobei die äußeren Ränder der Befestigungsschicht die äußere Berandung des flexiblen Substrats (3) bedecken und sich darüber hinaus erstrecken, so dass das flexible Substrat (3) auf der Substratablage befestigt wird, währen das Vakuum in den Rillen (2) der Substratablage unter den flexiblen Substrat (3) aufrechterhalten wird; und
Schritt 4: Durchführung von Produktionsprozessen der elektronischen Anzeigevorrichtung auf dem flexiblen Substrat, und dann Separieren des flexiblen Substrates (3) von der Substratablage.

9. Verfahren zur Herstellung einer flexiblen elektronischen Anzeigevorrichtung gemäß Anspruch 8, wobei die Ablage-Basisplatte (1) der Substratablage, die in Schritt 1 bereitgestellt wird, auch eine planare Randzone an der Peripherie der Rillenzone aufweist.

10. Verfahren zur Herstellung einer flexiblen elektronischen Anzeigevorrichtung gemäß Anspruch 8 oder 9, wobei in Schritt 4 das Separieren des flexiblen Substrates (3) von der Substratablage umfasst:
Schritt 41: Aufbringen von Photoresist auf die Befestigungsschicht (4) und dann Belichten und Entwickeln des Photoresists an der externen Begrenzung des flexiblen Substrates (3) und außerhalb der externen Begrenzung des flexiblen Substrates (3); und
Schritt 42: Wegätzen der Befestigungsschicht (4), welche nicht mittels des Photoresists auf der externen Begrenzung des flexiblen Substrates (3) und außerhalb der externen Begrenzung des flexiblen Substrates (3) bedeckt ist, und Abziehen des verbleibenden Photoresists, so dass das Vakuum zwischen dem flexiblen Substrat (3) und der Substratablage abgebaut wird, damit das flexible Substrat (3) von der Substratablage separiert wird.

11. Verfahren zur Herstellung einer flexiblen elektronischen Anzeigevorrichtung gemäß einem der Ansprüche 8-10, wobei in Schritt 3 die Dicke der abgeschiedenen Befestigungsschicht (4) 0,05 µm - 10 µm beträgt.

## Revendications

1. Un plateau pour substrat approprié pour supporter un substrat souple pendant la fabrication d'un dispositif d'affichage électronique souple sur ledit substrat souple, dans lequel il comprend une plaque de base de plateau (1), et la plaque de base de plateau (1) a une zone de rainures dans laquelle une pluralité de rainures (2) sont formées dans la plaque de base de plateau (1), **caractérisé en ce que** les profondeurs des rainures (2) ne dépassent pas 1 µm et les longueurs des côtés inférieurs des profils de section transversale des rainures (2) est m µm à n mm, dans laquelle, 1 ≤ m ≤ 10, 1 ≤ n ≤ 10.

2. Le plateau pour substrat selon la revendication 1, dans lequel la plaque de base de plateau présente également une zone de bord plane à la périphérie de la zone de rainures.

3. Le plateau pour substrat selon la revendication 1 ou 2, dans lequel la pluralité de rainures (2) sont des rainures en forme de bandes (2) s'étendant jusqu'à des bords de la zone de rainures.

4. Le plateau pour substrat selon l'une des revendications précédentes, dans lequel la pluralité de rainures en forme de bandes (2) comprend une pluralité de rainures en forme de bandes s'étendant transversalement (2) et une pluralité de rainures en forme de bandes s'étendant longitudinalement.

5. Le plateau pour substrat selon l'une des revendications précédentes, dans lequel les rainures en forme de bandes (2) s'étendent d'un bord latéral de la zone de rainures à un autre bord latéral à l'opposé dudit bord latéral.

6. Le plateau pour substrat selon l'une des revendications précédentes, dans lequel les profils de section transversale des rainures (2) sont un ou plusieurs profils choisis dans un groupe constitué par un cercle, une ellipse et un polygone.

7. Le plateau pour substrat selon l'une des revendications précédentes, dans lequel le matériau de la plaque de base de plateau (1) est choisi dans un groupe constitué de verre, de métal et de plastique.

8. Un procédé de fabrication d'un dispositif d'affichage électronique souple, **caractérisé en ce qu'**il comprend les étapes suivantes :
Etape 1 : fourniture d'un plateau pour substrat selon l'une des revendications 1 à 7, ledit plateau pour substrat comprenant une plaque de base de plateau (1), la plaque de base de plateau (1) ayant une zone de rainures dans laquelle une pluralité de rainures (2) sont formées dans la plaque de base de plateau (1),
Étape 2 : mise en place d'un substrat souple (3) sur la zone de rainures de la plaque de base de plateau (1) du plateau pour substrat ;
Etape 3 : mise en place du plateau de substrat avec le substrat souple (3) dans une chambre pour effectuer un traitement de pompage sous vide, et dépôt d'une couche de fixation (4) sur le substrat souple (3), les bords extérieurs de la couche de fixation recouvrant et dépassant la limite externe du substrat souple (3), fixant ainsi le substrat souple (3) sur le plateau de substrat tout en maintenant le degré de vide dans les rainures (2) du plateau pour substrat sous le substrat souple (3) ; et
Etape 4 : réalisation des processus de fabrication du dispositif d'affichage électronique sur le substrat souple, puis séparation du substrat souple (3) du plateau pour substrat.

9. Le procédé de fabrication d'un dispositif d'affichage électronique souple selon la revendication 8, dans lequel la plaque de base de plateau (1) du plateau pour substrat fournie à l'étape 1 présente également une zone de bord plane à la périphérie de la zone de rainures.

10. Le procédé de fabrication d'un dispositif d'affichage électronique souple selon la revendication 8 ou 9, dans lequel, dans l'étape 4, la séparation du substrat souple (3) du plateau pour substrat comprend :
Etape 41 : application d'une résine photosensible sur la couche de fixation (4), puis exposition et développement de la résine photosensible sur la limite externe du substrat souple (3) et hors de la limite externe du substrat souple (3) ; et
Etape 42 : attaque de la couche de fixation (4) qui n'est pas recouverte par la résine photosensible sur la limite externe du substrat souple (3) et hors de la limite externe du substrat souple (3), et enlèvement de la résine photosensible restante, de manière que le vide entre le substrat souple (3) et le plateau pour substrat se relâche, séparant ainsi le substrat souple (3) du plateau pour substrat.

11. Le procédé de fabrication d'un dispositif d'affichage électronique souple selon l'une des revendications 8 à 10, dans lequel, à l'étape 3, l'épaisseur de la couche de fixation (4) est déposée pour être de 0,05 µm à 10 µm.
